# EUROPÄISCHE PATENTSCHRIFT

(11) **EP 1 518 270 B1**
(45) Veröffentlichungstag und Bekanntmachung des Hinweises auf die Patenterteilung: **26.11.2008**
(21) Anmeldenummer: 03740078.5
(22) Anmeldetag: 10.06.2003
(51) Int. Cl.: H01L 23/31, H01L 21/56

(54) **VERFAHREN ZUM HERSTELLEN EINER VERPACKUNG FÜR HALBLEITERBAUELEMENTE**
METHOD FOR PRODUCING A PACKAGING FOR SEMICONDUCTOR COMPONENTS
PROCEDE DE REALISATION D'UN ENCAPSULAGE POUR COMPOSANTS SEMI-CONDUCTEURS

(30) Priorität: 17.06.2002 DE 10227059
(43) Veröffentlichungstag der Anmeldung: 30.03.2005
(73) Patentinhaber: Infineon Technologies AG, 81669 München (DE)
(72) Erfinder: ZACHERL, Juergen, 93093 Donaustauf (DE); BLASZCZAK, Stephan, 06632 Freyburg (DE); REISS, Martin, 01109 Dresden (DE); LUDEWIG, Sylke, 01217 Dresden (DE)
(74) Vertreter: Hudler, Frank
(86) Internationale Anmeldenummer: PCT/DE2003/001925
(87) Internationale Veröffentlichungsnummer: WO 2003/107417

(56) Entgegenhaltungen:
- US-A- 6 107 679
- US-A1- 2001 026 959
- PATENT ABSTRACTS OF JAPAN Bd. 0144, Nr. 48 (E-0983), 26. September 1990 (1990-09-26) & JP 2 178953 A (NEC CORP), 11. Juli 1990 (1990-07-11) -& JP 02 178953 A (NEC CORP) 11. Juli 1990 (1990-07-11)

## Beschreibung

Die Erfindung betrifft eine Verpackung für HalbleiterBauelemente, bei denen mindestens die Rückseite und die Seitenkanten eines auf einem Substrat montierten Chips durch eine Moldabdeckung umschlossen werden, wobei die für die Moldabdeckung verwendete Vergussmasse mit dem Substrat, eine kompakte Einheit bildend, verbunden wird.

Bei einer Reihe von Bauelementen, wie BOC-Bauelementen oder auch bei CSP (Chip Size Package)-Bauelementen, FBGA -(Fine Pitch Ball Grid Array)-, TBGA-(Tape Ball Grid Array)- oder µBGA-Bauelementen o.dgl., werden die Chips auf Substraten montiert, deren Abmessungen etwa denen der zu montierenden Chips entsprechen. Die unterschiedlichen Bezeichnungen sind zum Teil herstellertypische Angaben und kennzeichnen Unterschiede bzw. Feinheiten im Strukturaufbau. Im Interesse einer möglichst geringen Bauhöhe werden bei einigen Bauelementen die Chiprückseiten nicht abgedeckt, sondern höchstens lediglich die besonders empfindlichen Chipkanten durch eine Moldmasse umschlossen. Letzteres erfolgt durch Dispensen einer geeigneten Moldmasse (Vergussmasse) um die Chipkanten herum. Soll auch die Chiprückseite zusätzlich mit geschützt werden, müssen aufwändige Druck- oder Gießverfahren eingesetzt werden. Es versteht sich, dass die verschiedenen verwendeten Materialien für das Substrat, das Chip und die Vergussmasse teilweise erheblich unterschiedliche mechanische Eigenschaften und insbesondere unterschiedliche thermische Ausdehnungskoeffizienten besitzen. Für das Substrat kommen die gängigen Leiterplattenmaterialien, wie Hartpapier- oder Glasfasermaterialien zum Einsatz, bei denen als Bindemittel üblicherweise Kunstharz verwendet wird.

Beispiele derartiger Halbleiterbauelemente finden sich in der US 5 391 916 A, in der ein Hableiterbauelement beschrieben wird, dass mit einer Vergussmasse versehen ist, oder in der US 5 293 067 A, in der ein spezieller Chipträger für ein Chip on Board (COB) Bauelement beschrieben wird, um den mechanischen Stress zu reduzieren.

Durch geeignete Materialwahl lassen sich die Ausdehnungskoeffizienten in gewisser Weise so aufeinander abstimmen, dass der Unterschied der Ausdehnungskoeffizienten zwischen der jeweiligen Materialpaarung möglichst gering wird.

Es besteht jedoch kaum die Möglichkeit einer vollkommenen Anpassung. Das hat besonders bei BOC- bzw. COB-Bauelementen die fatale Folge, dass diese, wenn diese mit einer zusätzlichen Moldabdeckung geschützt werden, beim normalen Gebrauch einem extremen Stress unterworfen werden. Dieser Stress beruht im wesentlichen auf dem "Bimetalleffekt", welcher sich ergibt, wenn unterschiedliche Materialien mit unterschiedlichen Ausdehnungskoeffizienten schichtweise zusammengefügt werden.

Um wenigstens den Stress zwischen dem Substrat und dem Chip zu reduzieren, erfolgt deren Montage auf dem Substrat üblicherweise unter Zwischenlage eines thermische Spannungen ausgleichenden Tapes. Auf jeden Fall bestehen dann immer noch zwischen den unmittelbar miteinander in Kontakt stehenden Materialpaarungen Si-Chip/Moldmasse und Moldmasse/Substrat deutliche Differenzen der jeweiligen Ausdehnungskoeffizienten. Im ungünstigsten Fall kann es dabei zu einer Trennung der Verbindung und damit möglicherweise zum Totalausfall des Bauelementes kommen.

Bisher wurden, wie eingangs bereits erwähnt, verschiedene aufwändige Verfahren zum Schutz der Chips durchgeführt. So zum Beispiel Dispensen, um die besonders empfindlichen Chipkanten zu schützen, oder Drucken bzw. Molden, um einen kompletten Schutz des Chips einschließlich dessen Rückseite zu erreichen. Die Auswirkungen der thermomechanischen Spannungen zwischen den Materialpaarungen konnten jedoch nicht, bzw. nicht ausreichend behoben werden, so dass mit Stress bedingten Bauelementeausfällen immer gerechnet werden muss. Lösungsansätze, wie Material- und Designänderungen und ein Tapeunterstand verursachten jedoch andere Probleme, wie unabgedeckte Fuses.

Die JP-A-02 178 953 beschreibt eine Halbleitervorrichtung, bestehend aus einem Lead-Frame, der auf der Rückseite des Chipaufnahmebereiches mit einem porösen Harzfilm als Kleber beschichtet ist. Dieser poröse Harzfilm dient der Verbesserung der Haftung einer Umhüllungsmasse bei der fertig gestellten umhüllten Halbleitervorrichtung.

Der Erfindung liegt daher die Aufgabe zugrunde, ein Verfahren zum Herstellen einer Verpackung für Halbleiterbauelemente zu schaffen, mit der eine deutlich höhere Packagebelastung durch geringeren thermomechanischen Stress und gleichzeitig eine deutlich bessere Haftung der Moldabdeckung auf dem Substrat erreicht wird.

Die der Erfindung zugrundeliegende Aufgabenstellung wird bei einem Verfahren der eingangs genannten Art dadurch gelöst, dass das Substrat derart vorbehandelt wird, dass zumindest in dessen oberflächennahen Bereich eine in die Tiefe gehende mit porenförmigen Öffnungen versehene schwammartige Struktur entsteht und dass die aus dem Substrat und dem auf dem Substrat fertig montierten Chip bestehende Struktur vor dem Aufbringen der Moldabdeckung mindestens auf Schmelztemperatur der Moldmasse vorgewärmt wird, so dass Moldmaterial durch kapillarwirkung in das Substrat eindrigen kann.

Zusätzlich kann die Struktur, bestehend aus dem Substrat und dem auf dem Substrat fertig montierten Halbleiterchip, nach dem Aufbringen der Moldabdeckung kurzzeitig getempert werden.

Das Tempern wird bevorzugt bei einer Temperatur um die Schmelztemperatur der Moldmasse, oder geringfügig über der Schmelztemperatur vorgenommen, um eine möglichst große Eindringtiefe zu erreichen.

In einer Ausgestaltung der Erfindung kann die gesamte Oberfläche des Substrates oder das Substrat insgesamt mit einer schwammartigen Struktur versehen werden.

Die schwammartige Struktur kann bei einem Substrat aus einem Leiterplattenmaterial durch partielles Entfernen des Epoxydharzanteiles im Substrat hergestellt werden.

Eine andere Möglichkeit besteht darin, dass die schwammartige Struktur durch Nass- oder Trockenätzen hergestellt wird.

Weiterhin kann das Substrat während der Herstellung der schwammartigen Struktur teilweise mit einer Lötstoppmaske abgedeckt werden.

Eine besondere Ausgestaltung der Erfindung ist dadurch gekennzeichnet, dass die schwammartige Struktur bei einem Substrat aus einem Keramikmaterial dadurch hergestellt wird, dass dem Keramikmaterial vor dem Sintern kohlenstoffhaltige Partikel zugemischt werden und dass nach dem Sintern ein Glühprozess vorgenommen wird, bei dem die Partikel verbrannt und die gewünschten Hohlräume hergestellt werden.

Eine nicht-erfindungsgemäße Ausgestaltung des Verfahrens ist dadurch gekennzeichnet, dass das Substrat vor der Montage des Chips partiell mit einer dünnen Schicht Moldmasse beschichtet und anschließend bei einer Temperatur um oder über der Schmelztemperatur getempert wird. Das Aufbringen der Moldmasse kann einfach durch Drucken oder Dispensen erfolgen. Der Tempervorgang kann sowohl unmittelbar nach dem Aufbringen der Moldmasse, oder nach dem Aufbringen der Moldabdeckung nach Abschluss des Montagevorganges vorgenommen werden.

Diese Ausgestaltung des Verfahrens hat den Vorteil, dass die Substrate vorbehandelt werden können, ohne dass der technologische Ablauf des Montagevorganges beeinflusst wird.

Durch diese besonders einfache Lösung lässt sich der Ausdehnungskoeffizient des Leiterplattenmateriales an den Ausdehnungskoeffizienten des Moldmaterials weitgehend anpassen. Dadurch wird das bruchempfindliche Halbleiterchip von allen Seiten gleichmäßig durch Spannungen beaufschlagt und kann sich nicht mehr nur in einer Vorzugsrichtung verbiegen. Ein weiterer Vorteil ist darin zu sehen, dass durch den geringeren Stress höhere Packagebelastungen ermöglicht werden.

Weiterhin wird durch die Erfindung eine wesentlich höhere Haftung des Abdeckmateriales auf dem Substrat erreicht, da beide Materialien gewissermaßen miteinander verwachsen.

Die Erfindung soll nachfolgend an einem Ausführungsbeispiel näher erläutert werden. In den zugehörigen Zeichnungen zeigen:
- Fig. 1: eine schematische Schnittdarstellung eines BOC-Bauelementes (Stand der Technik);
- Fig. 2: eine schematische Darstellung einer erfindungsgemäße Verpackung für ein BOC-Bauelement; und
- Fig. 3: ein partiell mit einer Moldmasse beschichtetes und getempertes Substrat.

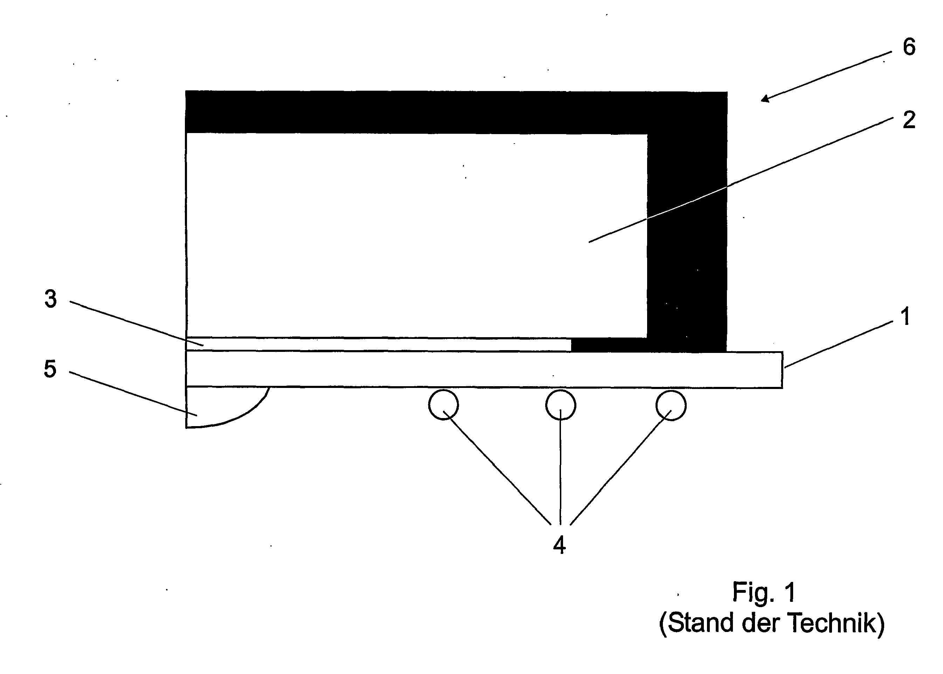

Um die Wirkungsweise der Erfindung gut darstellen zu können, wird zunächst der Strukturaufbau eines üblichen BOC-Bauelementes beschrieben. Fig. 1 zeigt ein derartiges nach dem Stand der Technik aufgebautes BOC-Bauelement in schematischer Darstellung. Die Grundlage für dieses Bauelement bildet ein Substrat 1, das aus den gängigen Leiterplattenmaterialien, wie Hartpapier- oder Glasfasermaterialien besteht, bei denen als Bindemittel üblicherweise Kunstharz eingesetzt wurde.

Auf diesem Substrat 1 ist ein Chip 2 unter Zwischenlage eines Tapes diegebondet. Die Unterseite des Substrates 1 ist mit nicht dargestellten Leitbahnen versehen, die einerseits mit Solderballs 4 und andererseits über übliche, nicht dargestellte Mikrodrähte mit dem Chip 2 verbunden ist, die durch einen zentralen Kanal im Substrat 1 verlaufen. Dieser zentrale Kanal ist zum Schutz der Mikrodrähte und der aktiven Seite des Chips 2 mit einem Bondkanalverschluss 5 aus einem Moldmaterial (Vergussmasse) verschlossen. Die Rückseite des Chips 2 (in Fig. 1 oben) und die Chipkanten sind durch eine Moldabdeckung 6 umschlossen, wobei die Moldabdeckung 6 seitlich des Chips 2 mit der Oberfläche des Substrates 1 durch Adhäsion verbunden. Die Moldabdeckung kann durch Drucken oder Dispensen hergestellt werden.

Ein derartiges Bauelement zeigt nun die eingangs beschriebenen Nachteile infolge der unterschiedlichen Ausdehnungskoeffizienten und mechanischen Eigenschaften der einzelnen Komponenten, die unmittelbar miteinander in Kontakt stehen. Hier setzt nun die Erfindung an.

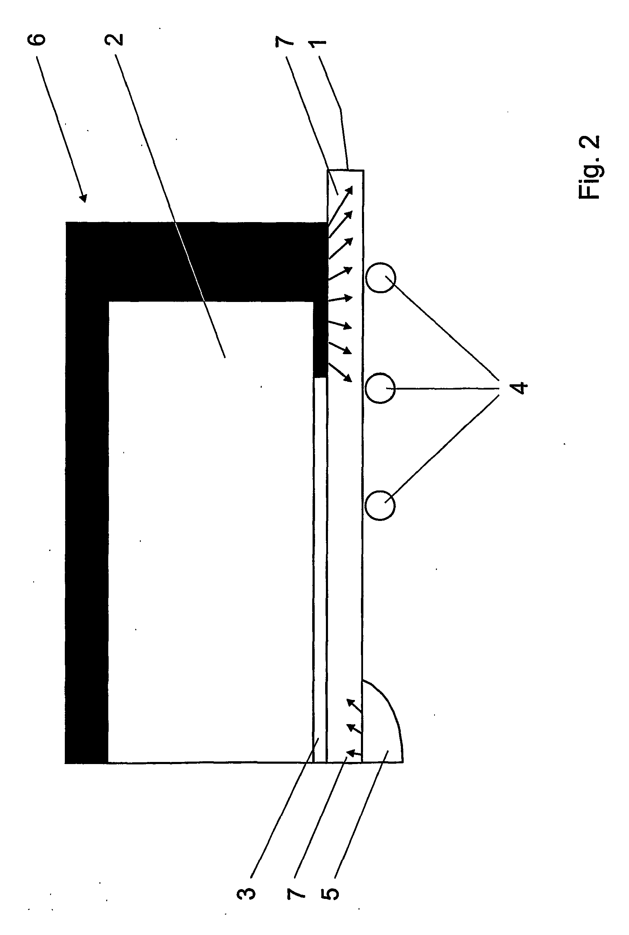

Um eine weitgehende Anpassung der Ausdehnungskomponenten des Moldmaterials und des Substrates und eine deutliche Verbesserung der Haftkraft zwischen Moldmasse und Substrat 1 zu erreichen, wird das Substrat 1 derart vorbehandelt, dass zumindest dessen oberflächennaher Bereich eine in die Tiefe gehende schwammähnliche Struktur erhält, in die das Moldmaterial beim Molden eindringen kann. Dieser Zustand ist in Fig. 2 dargestellt.

Die schwammartige Struktur 7 des Substrates 1 kann durch partielles Entfernen des Epoxydharzanteiles erzeugt werden, indem Nass- oder Trockenätzverfahren eingesetzt werden. Dieses Nass- oder Trockenätzen kann bedarfsweise auf bestimmte Bereiche des Substrates 1 beschränkt werden, indem diese teilweise mit einer Lötstoppmaske abgedeckt werden.

Selbstverständlich kann die schwammartige Struktur 7 auch durch mechanische Oberflächenbearbeitung des Substrates hergestellt werden, wobei hier der schwammartige Bereich allerdings nur auf den unmittelbar oberflächennahen Bereich des Substrates 1 begrenzt wäre. Auf jeden Fall wird hier zumindest ein Übergangsbereich geschaffen und eine deutliche Verbesserung der Haftkraft des Moldmaterials auf dem Substrat erreicht.

Anstelle der nachträglichen Bearbeitung des Substrates 1 kann selbstverständlich auch ein Substrat 1 eingesetzt werden, welches bereits bei dessen Herstellung eine schwammähnliche Struktur erhalten hat. Solche Substrate können auch aus einem Sintermaterial bestehen, bei dem nach dem Sintern durch Glühen Hohlräume erzeugt werden. Das lässt sich einfach dadurch realisieren, dass dem Sintermaterial Kohlenstoffhaltige Partikel geeigneter Größe beigemischt werden. Dies Partikel verbrennen dann beim Glühen und erzeugen die gewünschten Hohlräume im Substrat 1.

Um ein möglichst tiefes Eindringen des Moldmaterials in die schwammartige Struktur 7 des Substrates 1 zu erreichen, wird die Struktur, bestehend aus dem auf dem Substrat 1 fertig montierten Chip 2, vor dem Aufbringen der Moldabdeckung 6 mindestens auf die Schmelztemperatur der Moldmasse vorgewärmt. Zusätzlich kann die Baugruppe nach dem Aufbringen der Moldabdeckung 6 bei einer Temperatur um die Schmelztemperatur der Moldmasse oder geringfügig darüber getempert werden.

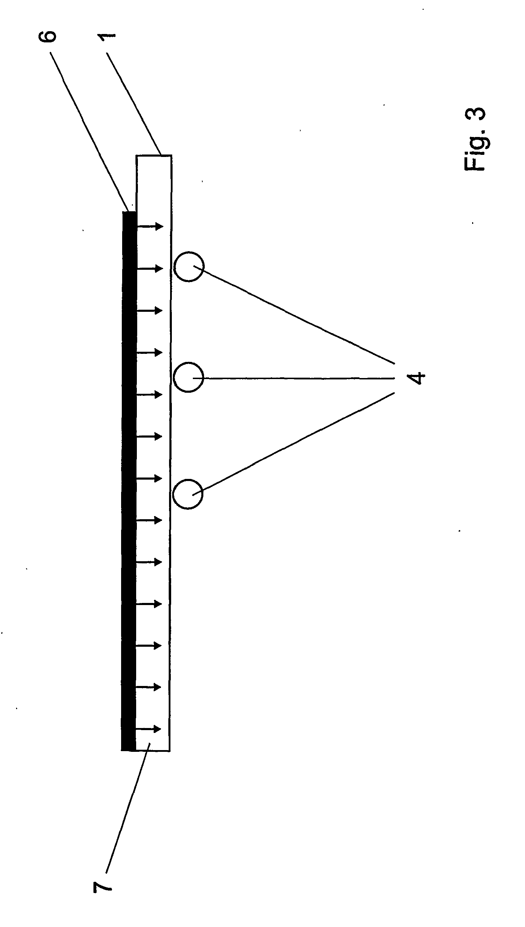

Eine nicht-erfindungsgemäße Alternative besteht darin, das Substrat 1 vor der Montage des Chips 2 partiell mit einer dünnen Schicht Moldmasse zu beschichten und anschließend bei einer Temperatur um oder über der Schmelztemperatur der Moldmasse zu tempern (Fig. 3). Das Aufbringen der Moldmasse auf das Substrat 1 kann einfach durch Drucken oder Dispensen erfolgen. Der zweckmäßige Tempervorgang kann sowohl unmittelbar nach dem Aufbringen der Moldmasse, oder nach dem Aufbringen der Moldabdeckung 6 nach Abschluss des Montagevorganges vorgenommen werden.

Diese Ausgestaltung hat den Vorteil, dass die Substrate vorbehandelt werden können, ohne dass der technologische Ablauf des Montagevorganges beeinflusst wird.

### Bezugszeichenliste

- 1: Substrat
- 2: Chip
- 3: Tape
- 4: Solderball
- 5: Bondkanalverschluss
- 6: Moldabdeckung
- 7: schwammartige Struktur

## Patentansprüche

1. verfahren zum Herstellen einer Verpackung für HalbleiterBauelemente, bei denen mindestens die Rückseite und die Seitenkanten eines auf einem Substrat montierten Chips durch eine Moldabdeckung umschlossen sind, wobei die für die Moldabeckung verwendete Vergussmasse mit dem Substrat, eine kompakte Einheit bildend, verbunden wird, **dadurch gekennzeichnet, dass** das Substrat (1) derart vorbehandelt wird, dass zumindest in dessen oberflächennahen Bereich eine in die Tiefe gehende mit porenförmigen Öffnungen versehene schwammartige Struktur (7) entsteht und dass die aus dem Substrat und dem auf dem Substrat (1) fertig montierten Chip (2) bestehende Struktur vor dem Aufbringen der Moldabdeckung (6) mindestens auf die Schmelztemperatur der Moldmasse vorgewärmt wird, so dass Moldmaterial durch kapillarwirkung in das Substrat eindringen kann.

2. Verfahren nach Anspruche 1, **dadurch gekennzeichnet, dass** die Struktur, bestehend aus dem Substrat und dem auf dem Substrat (1) fertig montierten Chip (2) bestehende Struktur nach dem Aufbringen der Moldabdeckung (6) getempert wird.

3. Verfahren nach Anspruch 2, **dadurch gekennzeichnet, dass** das Tempern bei einer Temperatur um die Schmelztemperatur der Moldmasse erfolgt.

4. Verfahren nach Anspruch 1, **dadurch gekennzeichnet, dass** die gesamte Oberfläche des Substrates (1) mit einer schwammartige Struktur (7) versehen wird.

5. Verfahren nach Anspruch 1, **dadurch gekennzeichnet, dass** das Substrat (1) insgesamt mit einer schwammartigen Struktur (7) versehen wird.

6. Verfahren nach einem der Anspruch 1 bis 5, **dadurch gekennzeichnet, dass** die schwammartige Struktur (7) bei einem Substrat (1) aus **einem Leiterplattenmaterial** durch partielles Entfernen des Epoxydharzanteiles im Substrat (1) hergestellt wird.

7. Verfahren nach Anspruch 6, **dadurch gekennzeichnet, dass** die schwammartige Struktur (7) durch Nass- oder Trockenätzen hergestellt wird.

8. Verfahren nach Anspruch 6 und 7, **dadurch gekennzeichnet, dass** das Substrat (1) während der Herstellung der schwammartigen Struktur (7) teilweise mit einer Lötstoppmaske abgedeckt wird.

9. Verfahren nach Anspruch 6, **dadurch gekennzeichnet, dass** die schwammartige Struktur (7) bei einem Substrat (1) aus einem Keramikmaterial **dadurch** hergestellt wird, dass dem Keramikmaterial vor dem Sintern kohlenstoffhaltige Partikel zugemischt werden und dass nach dem Sintern ein Glühprozess vorgenommen wird, bei dem die Partikel verbrannt und die gewünschten Hohlräume hergestellt werden.

## Claims

1. Method for producing a package for semiconductor components in which at least the rear side and the side edges of a chip mounted on a substrate are enclosed by a moulding covering, the potting compound used for the moulding covering being connected to the substrate here, in a manner forming a compact unit, **characterized in that** the substrate (1) is pre-treated in such a way that a sponge-like structure (7) which is provided with porous openings and extends into the depth arises at least **in that** region of said substrate which is near the surface, and **in that** the structure comprising the substrate and the chip (2) finally mounted on the substrate (1) is preheated at least to the melting point of the moulding compound before the application of the moulding covering (6), such that moulding material can penetrate into the substrate through capillary action.

2. Method according to Claim 1, **characterized in that** the structure comprising the substrate and the chip (2) finally mounted on the substrate (1) is subjected to heat treatment after the application of the moulding covering (6).

3. Method according to Claim 2, **characterized in that** the heat treatment is effected at a temperature around the melting point of the moulding compound.

4. Method according to Claim 1, **characterized in that** the entire surface of the substrate (1) is provided with a sponge-like structure (7).

5. Method according to Claim 1, **characterized in that** the substrate (1) in its entirety is provided with a sponge-like structure (7).

6. Method according to any one of Claims 1 to 5, **characterized in that**, in the case of a substrate (1) composed of **a printed circuit board material,** the sponge-like structure (7) is produced by partial removal of the epoxy resin portion in the substrate (1).

7. Method according to Claim 6, **characterized in that** the sponge-like structure (7) is produced by wet or dry etching.

8. Method according to Claims 6 and 7, **characterized in that** the substrate (1) is partially covered with a soldering resist mask during the production of the sponge-like structure (7).

9. Method according to Claim 6, **characterized in that**, in the case of a substrate (1) composed of a ceramic material, the sponge-like structure (7) is produced by carbon-containing particles being admixed with the ceramic material before sintering and an annealing process being performed after sintering, during which process the particles are burned and the desired cavities are produced.

## Revendications

1. Procédé de réalisation d'une encapsulation pour composants semi-conducteurs, dans lequel au moins le côté arrière et les bords latéraux d'une puce montée sur un substrat sont englobés dans un recouvrement moulé, la pâte de coulée utilisée pour le recouvrement moulé étant reliée au substrat en formant une unité compacte,
**caractérisé en ce que**
le substrat (1) est prétraité de manière à obtenir au moins dans sa partie proche de la surface une structure (7) en forme d'éponge dotée d'ouvertures poreuses s'étendant en profondeur et **en ce que** la structure constituée du substrat et de la puce (2) montée finalement sur le substrat (1) est préchauffée au moins à la température de fusion de la pâte de moulage avant l'application du recouvrement moulé (6), de telle sorte que le matériau de moulage puisse pénétrer dans le substrat par capillarité.

2. Procédé selon la revendication 1, **caractérisé en ce que** la structure constituée du substrat et de la puce (2) montée finalement sur le substrat (1) est maintenue à température après l'application du recouvrement moulé (6).

3. Procédé selon la revendication 2, **caractérisé en ce que** le maintien à température est effectué à une température proche de la température de fusion de la pâte de moulage.

4. Procédé selon la revendication 1, **caractérisé en ce que** la totalité de la surface du substrat (1) est dotée d'une structure (7) en éponge.

5. Procédé selon la revendication 1, **caractérisé en ce que** la totalité du substrat (1) est dotée d'une structure (7) en éponge.

6. Procédé selon l'une des revendications 1 à 5, **caractérisé en ce que** lorsque le substrat (1) est constitué d'un matériau de carte de circuit, la structure (7) en éponge est réalisée dans le substrat (1) par enlèvement partiel de la résine époxy qu'il contient.

7. Procédé selon la revendication 6, **caractérisé en ce que** la structure (7) en éponge est réalisée par gravure en conditions humides ou en conditions sèches.

8. Procédé selon les revendications 6 et 7, **caractérisé en ce que** pendant la réalisation de la structure (7) en éponge, le substrat (1) est partiellement recouvert par un masque d'arrêt de soudure.

9. Procédé selon la revendication 6, **caractérisé en ce que** lorsque le substrat (1) est réalisé en un matériau céramique, la structure (7) en éponge est réalisée en mélangeant, avant le frittage, des particules contenant du carbone avec le matériel céramique et **en ce qu'**après le frittage, on réalise une opération de recuit dans laquelle les particules sont brûlées pour former les espaces creux souhaités.
